# EUROPEAN PATENT SPECIFICATION

(11) **EP 2 930 213 B1**
(45) Date of publication and mention of the grant of the patent: **25.08.2021**
(21) Application number: 13860333.7
(22) Date of filing: 03.12.2013
(51) Int. Cl.: C08L 83/04, C08K 3/26, C08K 5/3472, C08K 9/02, C08K 9/06, H01L 23/28, H01L 23/29, H01L 23/31, H01L 33/56

(54) **CURABLE SILICONE COMPOSITION AND OPTICAL SEMICONDUCTOR DEVICE**
HÄRTBARE SILIKONZUSAMMENSETZUNG UND OPTISCHES HALBLEITERBAUELEMENT
COMPOSITION DE SILICONE DURCISSABLE ET DISPOSITIF OPTIQUE À SEMI-CONDUCTEUR

(30) Priority: 07.12.2012 JP 2012268740; 19.04.2013 JP 2013088755
(43) Date of publication of application: 14.10.2015
(73) Proprietor: DuPont Toray Specialty Materials Kabushiki Kaisha, Tokyo (JP)
(72) Inventor: MIYAMOTO, Yusuke, Fuchu-shi Tokyo 183-0006 (JP)
(74) Representative: Murgitroyd & Company
(86) International application number: PCT/JP2013/082906
(87) International publication number: WO 2014/088115

(56) References cited:
- EP-A1- 1 627 899
- WO-A2-2011/093353
- JP-A- S5 214 654
- JP-A- S5 558 253
- JP-A- H09 316 336
- JP-A- 2002 212 449
- JP-A- 2004 168 920
- JP-A- 2006 056 986
- JP-A- 2008 150 505
- JP-A- 2008 150 505
- JP-A- 2008 297 397
- JP-A- 2010 059 237

## Description

### TECHNICAL FIELD

The present invention relates to a curable silicone composition and an optical semiconductor device produced using the composition.

### BACKGROUND ART

Curable silicone compositions that cure by a hydrosilylation reaction are used for sealing, covering, or adhering optical semiconductor elements in optical semiconductor devices. In these compositions, it is required that the cured product thereof does not noticeably discolor due to thermal aging, and it has recently become necessary to suppress discoloration of silver electrodes and silver plating of substrates in the optical semiconductor device due to sulfur-containing gas such as hydrogen sulfide in the air.

For this reason, Patent Document 1 proposes a curable silicone composition comprising an organopolysiloxane having at least two alkenyl groups, an organopolysiloxane having at least two silicon-bonded hydrogen atoms, a zinc compound such as zinc carbonate or zinc oxide, and a hydrosilylation reaction catalyst; and Patent Document 2 proposes a curable silicone composition comprising an organopolysiloxane having at least two alkenyl groups, an organopolysiloxane having at least two silicon-bonded hydrogen atoms, a zinc compound obtained by reacting not less than 1.5 moles and less than 2 moles of acid relative to 1 mole of at least one type selected from the group consisting of zinc oxide, zinc carbonate, zinc hydroxide, zinc chloride, zinc sulfate, and zinc nitrate.

However, it was found that in the abovementioned compositions, there is the problem that during storage, zinc oxide and the silicon-bonded hydrogen atoms in the organopolysiloxane react, and the curability thereof decreases over time, and there is also the problem that the cured product thereof yellows due to thermal aging. Furthermore, in the abovementioned compositions it was found that there is the problem that discoloration of silver electrodes and silver plating of substrates by sulfur-containing gas in the air cannot be sufficiently suppressed.

The following documents may be useful in understanding the background to the present disclosure: WO 2011/093353 A2; JP 2008 150505 A; and EP 1 627 899 A1.

### PRIOR ART DOCUMENTS

### Patent Documents

Patent Document 1: Japanese Unexamined Patent Application Publication No. 2011-178983A; and Patent Document 2: WO2012/067153 pamphlet

### SUMMARY OF INVENTION

### Technical Problem

An object of the present invention is to provide a curable silicone composition that has excellent storage stability before curing, and when cured, forms a cured product that undergoes minimal yellowing due to thermal aging and sufficiently suppresses discoloration of silver electrodes and silver plating of substrates due to sulfur-containing gas in the air, and an optical semiconductor device that sufficiently suppresses discoloration of silver electrodes and silver plating of substrates due to sulfur-containing gas in the air.

### Solution to Problem

The curable silicone composition of the present invention comprises at least:
(A) an organopolysiloxane having at least two silicon-bonded alkenyl groups per molecule;
(B) an organopolysiloxane having at least two silicon-bonded hydrogen atoms per molecule, in an amount such that the number of silicon-bonded hydrogen atoms in this component is from 0.1 to 10 moles per 1 mole of the alkenyl groups in component (A);
(C) at least one type of fine powder having mass-average particle diameter of from 0.1 nm to 5 µm, selected from the group consisting of zinc oxide fine powders surface-coated with an oxide and/or hydroxide of at least one element selected from the group consisting of Al, Ag, Cu, Fe, Sb, Si, Sn, Ti, Zr, and rare earth elements, zinc oxide fine powders surface-treated with an organosilicon compound not having an alkenyl group selected from the group consisting of organosilazans and organohydrogenpolysiloxanes, in an amount of from 1 ppm to 10% of the composition in terms of mass units; and
(D) an effective amount of a hydrosilylation reaction catalyst.

Furthermore, the optical semiconductor device of the present invention is obtained by sealing, covering, or adhering an optical semiconductor element in the device using the aforementioned curable silicone composition.

### Effects of Invention

The curable silicone composition of the present invention is characterized by having excellent storage stability before curing, and when cured, forming a cured product that undergoes minimal yellowing due to thermal aging and sufficiently suppresses discoloration of silver electrodes and silver plating of substrates in the optical semiconductor device due to sulfur-containing gas in the air. The optical semiconductor device of the present invention is further characterized by sufficiently suppressing discoloration of silver electrodes and silver plating of substrates due to sulfur-containing gas in the air.

### BRIEF DESCRIPTION OF THE DRAWINGS

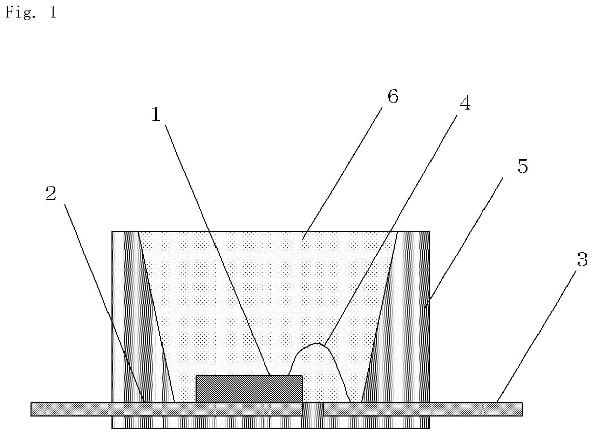

FIG. 1 is a cross-sectional drawing of an LED that is an example of an optical semiconductor device of the present invention.

### DESCRIPTION OF EMBODIMENTS

### [Curable Silicone Composition]

First, the curable silicone composition of the present invention will be described in detail.

Component (A) is an organopolysiloxane having at least two silicon-bonded alkenyl groups per molecule, and is a main component of the composition. Examples of the alkenyl groups in component (A) include alkenyl groups having from 2 to 12 carbons such as a vinyl group, allyl group, butenyl group, pentenyl group, hexenyl group, heptenyl group, octenyl group, nonenyl group, decenyl group, undecenyl group, and dodecenyl group, and a vinyl group is preferable. Examples of a group bonding to a silicon atom other than alkenyl groups in component (A) include alkyl groups having from 1 to 12 carbons such as a methyl group, ethyl group, propyl group, isopropyl group, butyl group, isobutyl group, tert-butyl group, pentyl group, neopentyl group, hexyl group, cyclohexyl group, heptyl group, octyl group, nonyl group, decyl group, undecyl group, and dodecyl group; aryl groups having from 6 to 20 carbons such as a phenyl group, tolyl group, xylyl group, and naphthyl group; aralkyl groups having from 7 to 20 carbons such as a benzyl group, phenethyl group, and phenylpropyl group; and groups in which some or all of the hydrogen atoms of these groups are substituted with halogen atoms such as fluorine atoms, chlorine atoms, or bromine atoms. The silicon atoms in component (A) may also have small quantities of hydroxyl groups or alkoxy groups such as methoxy groups and ethoxy groups within a range that does not impair the object of the present invention.

No particular limitation is placed on the molecular structure of component (A), and this structure may be, for example, straight, partially branched straight, branched, cyclic, or three-dimensional net-like. Component (A) may be a single organopolysiloxane having these molecular structures or a mixture of two or more types of organopolysiloxane having these molecular structures.

Such a component (A) is preferably an organopolysiloxane expressed by the average unit formula:

(R¹SiO_{3/2})ₐ(R²R³SiO_{2/2})_{b}(R⁴R⁵R⁶SiO_{1/2})_{c}(SiO_{4/2})_{d}

In the formula, R¹ to R⁶ are identical or different types of monovalent hydrocarbon group. Examples of the monovalent hydrocarbon groups of R¹ to R⁶ include, similar to above, alkyl groups, alkenyl groups, aryl groups, aralkyl groups, and groups in which some or all of the hydrogen atoms of these groups are substituted with halogen atoms such as fluorine atoms, chlorine atoms, or bromine atoms. Furthermore, the content of alkenyl groups in component (A) is preferably from 0.01 to 50 mol% of the total monovalent hydrocarbon groups of R¹ to R⁶, more preferably from 0.05 to 40 mol%, and particularly preferably from 0.09 to 32 mol%. This is because when the content of alkenyl groups in component (A) is too low, a cured product may not be obtained, and when the content of alkenyl groups in component (A) is too high, mechanical properties of the obtained cured product may be deteriorated. Moreover, the alkenyl groups in component (A) are preferably at both terminals of the organopolysiloxane molecule. The molar content (mol%) of the alkenyl group in the total monovalent hydrocarbon groups in component (A) can be measured by analytical methods exemplified by Fourier transform infrared spectrophotometer (FT-IR), nuclear magnetic resonance (NMR), gel permeation chromatography (GPC), and the like.

Moreover, a, b, c, and d represent molar ratios of the respective siloxane units, and a + b + c + d = 1.0, 0 ≤ a ≤ 1.0, 0 ≤ b ≤ 1.0, 0 ≤ c < 0.9, and 0 ≤ d < 0.5.

Component (A) is an organopolysiloxane that is a liquid or solid at 25°C. If component (A) is a liquid at 25°C, its viscosity at 25°C is preferably in a range of from 1 to 1,000,000 mPa·s, and more preferably in a range of from 10 to 1,000,000 mPa·s. The viscosity of the organopolysiloxane at 25°C may be determined based on JIS K 7117-1 using a B type viscometer, for example.

Component (B) is an organopolysiloxane having at least two silicon-bonded hydrogen atoms per molecule, and is a crosslinking agent of the composition. Examples of a group bonding to a silicon atom other than a hydrogen atom in component (B) include alkyl groups having from 1 to 12 carbons such as a methyl group, ethyl group, propyl group, isopropyl group, butyl group, isobutyl group, tert-butyl group, pentyl group, neopentyl group, hexyl group, cyclohexyl group, heptyl group, octyl group, nonyl group, decyl group, undecyl group, and dodecyl group; aryl groups having from 6 to 20 carbons such as a phenyl group, tolyl group, xylyl group, and naphthyl group; aralkyl groups having from 7 to 20 carbons such as a benzyl group, phenethyl group, and phenyl propyl group; and groups in which some or all of the hydrogen atoms of these groups are substituted with halogen atoms such as fluorine atoms, chlorine atoms, or bromine atoms. The silicon atoms in component (B) may also have small quantities of hydroxyl groups or alkoxy groups such as methoxy groups and ethoxy groups within a range that does not impair the object of the present invention.

No particular limitation is placed on the molecular structure of component (B), and this structure may be straight, partially branched straight, branched, cyclic, or three-dimensional net-like. The molecular structure of component (B) is preferably partially branched straight, branched, or three-dimensional net-like.

Such a component (B) is preferably an organopolysiloxane expressed by, for example, the average composition formula:

R⁷ₑH_{f}SiO_{[(4-e-f)/2]}

In the formula, R⁷ is an optionally substituted monovalent hydrocarbon group excluding aliphatic unsaturated hydrocarbon groups, examples of which include, similar to above, alkyl groups, aryl groups, aralkyl groups, and groups in which some or all of the hydrogen atoms of these groups are substituted with halogen atoms such as fluorine atoms, chlorine atoms, or bromine atoms.

Moreover, in the formula, e and f have values so as to satisfy the following formulae: 1.0 < e ≤ 2.0, 0.1 < f < 1.0, and 1.5 ≤ e + f< 2.7.

Component (B) is a liquid or solid at 25°C. If component (B) is a liquid at 25°C, the viscosity of the liquid at 25°C is preferably not greater than 10,000 mPa·s, more preferably in a range of from 0.1 to 5,000 mPa·s, and particularly preferably is in a range of from 0.5 to 1,000 mPa·s. The viscosity of the organopolysiloxane at 25°C may be determined based on JIS K 7117-1 using a B type viscometer, for example.

Component (B) is not particularly limited to a specific organopolysiloxane as long as the object of the present invention can be achieved. Examples of component (B) include one or more types selected from the group consisting of 1,1,3,3-tetramethyldisiloxane, 1,3,5,7-tetramethylcyclotetrasiloxane, tris(dimethylhydrogensiloxy)methylsilane, tris(dimethylhydrogensiloxy)phenylsilane, 1-glycidoxypropyl-1,3,5,7-tetramethylcyclotetrasiloxane, 1,5-glycidoxypropyl-1,3,5,7-tetramethylcyclotetrasiloxane, 1-glycidoxypropyl-5-trimethoxysilylethyl-1,3,5,7-tetramethylcyclotetrasiloxane, methylhydrogenpolysiloxane capped at both molecular terminals with trimethylsiloxy groups, copolymers of dimethylsiloxane and methylhydrogensiloxane capped at both molecular terminals with trimethylsiloxy groups, dimethylpolysiloxane capped at both molecular terminals with dimethylhydrogensiloxy groups, copolymers of dimethylsiloxane and methylhydrogensiloxane capped at both molecular terminals with dimethylhydrogensiloxy groups, copolymers of methylhydrogensiloxane and diphenylsiloxane capped at both molecular terminals with trimethylsiloxy groups, copolymers of methylhydrogensiloxane, diphenylsiloxane, and dimethylsiloxane capped at both molecular terminals with trimethylsiloxy groups, copolymers comprising (CH₃)₂HSiO_{1/2} units and SiO_{4/2} units, and copolymers comprising (CH₃)₂HSiO_{1/2} units and SiO_{4/2} units and (C₆H₅)SiO_{3/2} units.

The content of component (B) is in an amount that a content of the silicon-bonded hydrogen atoms in this component is from 0.1 to 10 moles, and preferably from 0.5 to 5 moles, per 1 mole of the alkenyl groups in component (A). This is because when the content of component (B) is not greater than the upper limit of the range described above, decrease in mechanical properties of the obtained cured product can be suppressed, and, on the other hand, when the content of component (B) is not less than the lower limit of the range described above, the obtained composition can be sufficiently cured. The amount of the silicon-bonded hydrogen atoms in component (B) can be measured by analytical methods exemplified by Fourier transform infrared spectrophotometer (FT-IR), nuclear magnetic resonance (NMR), gel permeation chromatography (GPC), and the like.

Component (C) is a characteristic component for sufficiently suppressing discoloration of silver electrodes and silver plating of substrates in the optical semiconductor device due to sulfur-containing gas in the air. Such a component (C) is at least one type of fine powder having mass-average particle diameter of from 0.1 nm to 5 µm, selected from the group consisting of zinc oxide fine powders surface-coated with an oxide and/or hydroxide of at least one element selected from the group consisting of Al, Ag, Cu, Fe, Sb, Si, Sn, Ti, Zr, and rare earth elements, and zinc oxide fine powders surface-treated with an organosilicon compound not having an alkenyl group selected from the group consisting of organosilazans and organohydrogenpolysiloxanes. The mass-average particle diameter can be measured by laser diffraction/scattering. "Mass-average particle diameter" pertaining to the present invention refers to the particle diameter when cumulative mass is 50% (D50), which is obtained by measuring particle diameter distribution.

Examples of rare earth elements in the zinc oxide fine powder surface-coated with an oxide include yttrium, cerium, and europium. Examples of the oxide on the surface of the zinc oxide fine powder include Al₂O₃, AgO, Ag₂O, Ag₂O₃, CuO, Cu₂O, FeO, Fe₂O₃, Fe₃O₄, Sb₂O₃, SiO₂, SnO₂, Ti₂O₃, TiO₂, Ti₃O₅, ZrO₂, Y₂O₃, CeO₂, Eu₂O₃, and mixtures of two or more of these oxides, as well as hydrates of oxides such as Al₂O₃·nH₂O, Fe₂O₃·nH₂O, Fe₃O₄·nH₂O, Sb₂O₃·nH₂O, SiO₂·nH₂O, TiO₂·nH₂O, ZrO₂·nH₂O, CeO₂·nH₂O, and the like. Among these, Al₂O₃, SiO₂, and hydrates thereof are preferable. Note that n is normally a positive integer, but is not necessarily limited to an integer depending on the degree of dehydration.

Examples of rare earth elements in the zinc oxide fine powder surface-coated with a hydroxide include yttrium, cerium, and europium. Examples of the hydroxide on the surface of the zinc oxide fine powder include Al(OH)₃, Cu(OH)₂, Fe(OH)₃, Ti(OH)₄, Zr(OH)₃, Y(OH)₃, Ce(OH)₃, Ce(OH)₄, and mixtures of two or more of these oxides, as well as hydrates of oxides such as Ce(OH)₃·nH₂O. Among these, Al(OH)₃ is preferable. Note that n is normally a positive integer, but is not necessarily limited to an integer depending on the degree of dehydration.

Furthermore, the abovementioned zinc oxide surface-coated with an oxide may be further surface-coated with the abovementioned hydroxides, and may also be surface-coated with oxides other than those mentioned above. Furthermore, the abovementioned zinc oxide surface-coated with a hydroxide may be further surface-coated with the abovementioned oxides, and may also be surface-coated with hydroxides other than those mentioned above. Component (C) may also be zinc oxide surface-coated with the abovementioned oxides and the abovementioned hydroxides. Examples of combinations of oxides and hydroxides include a combination of Al₂O₃ and Al(OH)₃ and a combination of SiO₂ and Al(OH)₃.

In the zinc oxide fine powder surface-treated with an organosilicon compound, the organosilicon compound does not have an alkenyl group and is selected from the group consisting of organosilazanes such as hexamethyldisilazane; and organohydrogenpolysiloxanes.

The content of component (C) is an amount in a range of from 1 ppm to 10%, and preferably an amount in a range of from 1 ppm to 5%, of the composition in terms of mass units. This is because when the content of component (C) is not less than the lower limit of the range described above, discoloration of silver electrodes and silver plating of substrates in the optical semiconductor device due to sulfur-containing gas is sufficiently suppressed, and when the content is not greater than the upper limit of the range described above, the fluidity of the resulting composition is not diminished.

Component (D) is a hydrosilylation reaction catalyst used to accelerate the hydrosilylation reaction of the present composition. Such a component (D) is preferably a platinum element catalyst or a platinum element compound catalyst, and examples thereof include platinum-based catalysts, rhodium-based catalysts, and palladium-based catalysts. Among such hydrosilylation reaction catalysts, platinum-based catalysts are preferable due to the ability to remarkably promote the hydrosilylation reaction between components (A) and (B). Examples of such platinum-based catalysts include platinum fine powders, platinum black, chloroplatinic acid, alcohol-modified products of chloroplatinic acid, complexes of chloroplatinic acid and diolefin, platinum-olefin complexes, platinum-carbonyl complexes such as platinum bis-(acetoacetate) and platinum bis-(acetylacetonate), chloroplatinic acid-alkenylsiloxane complexes such as chloroplatinic acid-divinyltetramethyldisiloxane complexes and chloroplatinic acid-tetravinyltetramethylcyclotetrasiloxane complexes, platinum-alkenylsiloxane complexes such as platinum-divinyltetramethyldisiloxane complexes and platinum-tetravinyltetramethylcyclotetrasiloxane complexes, and complexes of chloroplatinic acid and acetylene alcohols. Platinum-alkenylsiloxane complexes are particularly preferable due to their excellent effect of accelerating hydrosilylation reactions. One type of these hydrosilylation reaction catalysts may be used alone, or two or more types may be used in combination.

The alkenylsiloxane used in the platinum-alkenylsiloxane complex is not particularly limited, and examples thereof include 1,3-divinyl-1,1,3,3-tetramethyldisiloxane, 1,3,5,7-tetramethyl-1,3,5,7-tetravinylcyclotetrasiloxane, alkenylsiloxane oligomers in which some of the methyl groups of these alkenylsiloxanes are substituted with ethyl groups, phenyl groups, or the like, and alkenylsiloxane oligomers in which the vinyl groups of these alkenylsiloxanes are substituted with allyl groups, hexenyl groups, or the like. In particular, 1,3-divinyl-1,1,3,3-tetramethyldisiloxane is preferable due to the favorable stability of the platinum-alkenylsiloxane complex that is produced.

In order to improve the stability of the platinum-alkenylsiloxane complexes, it is preferable to dissolve these platinum-alkenylsiloxane complexes in an alkenylsiloxane oligomer such as 1,3-divinyl-1,1,3,3-tetramethyldisiloxane, 1,3-diallyl-1,1,3,3-tetramethyldisiloxane, 1,3-divinyl-1,3-dimethyl-1,3-diphenyldisiloxane, 1,3-divinyl-1,1,3,3-tetraphenyldisiloxane, or 1,3,5,7-tetramethyl-1,3,5,7-tetravinylcyclotetrasiloxane or an organosiloxane oligomer such as a dimethylsiloxane oligomer, and it is particularly preferable to dissolve the complexes in an alkenylsiloxane oligomer.

The content of component (D) is a quantity effective in promoting curing of the composition. Specifically, the content is preferably an amount such that the catalyst metal atoms in component (D) are within the range of from 0.01 to 500 ppm in terms of mass units of the composition, more preferably within the range of from 0.01 to 100 ppm, and particularly preferably within the range of from 0.1 to 50 ppm. This is because when the content of component (D) is not less than the lower limit of the range described above, the obtained composition can be sufficiently cured, and, on the other hand, when the content of component (D) is not greater than the upper limit of the range described above, coloration of the obtained cured product can be suppressed.

The composition may also contain (E) a hydrosilylation reaction inhibitor as an optional component for extending working life at room temperature and improving storage stability. Examples of component (E) include alkyne alcohols such as 1-ethynylcyclohexan-1-ol, 2-methyl-3-butyn-2-ol, 3,5-dimethyl-1-hexyn-3-ol, and 2-phenyl-3-butyn-2-ol; enyne compounds such as 3-methyl-3-penten-1-yne and 3,5-dimethyl-3-hexen-1-yne; methylalkenylsiloxane oligomers such as 1,3,5,7-tetramethyl-1,3,5,7-tetravinylcyclotetrasiloxane and 1,3,5,7-tetramethyl-1,3,5,7-tetrahexenylcyclotetrasiloxane; alkynoxysilanes such as dimethyl bis(3-methyl-1-butyn-3-oxy)silane and methylvinyl bis(3-methyl-1-butyn-3-oxy)silane, and triallylisocyanurate compounds.

The content of component (E) is not particularly limited but is an amount sufficient to suppress gelling or to suppress curing at the time of the mixing of components (A) to (D) and is an amount sufficient to enable long-term storage. Specifically, the content of component (E) is preferably in a range of from 0.0001 to 5 parts by mass, and more preferably in a range of from 0.01 to 3 parts by mass, per 100 parts total mass of components (A) to (D).

In addition, the composition may also contain (F) a triazole-based compound as an optional component to enable further suppression of discoloration of silver electrodes and silver plating of substrates due to sulfur-containing gas in the air. Examples of such a component (F) include 1H-1,2,3-triazole, 2H-1,2,3-triazole, 1H-1,2,4-triazole, 4H-1,2,4-triazole, 2-(2'-hydroxy-5'-methylphenyl)benzotriazole, 1H-1,2,3-triazole, 2H-1,2,3-triazole, 1H-1,2,4-triazole, 4H-1,2,4-triazole, benzotriazole, tolyltriazole, carboxybenzotriazole, 1H-benzotriazole-5-methylcarboxylate, 3-amino-1,2,4-triazole, 4-amino-1,2,4-triazole, 5-amino-1,2,4-triazole, 3-mercapto-1,2,4-triazole, chlorobenzotriazole, nitrobenzotriazole, aminobenzotriazole, cyclohexano[1,2-d]triazole, 4,5,6,7-tetrahydroxytolyltriazole, 1-hydroxybenzotriazole, ethylbenzotriazole, naphthotriazole, 1 -N,N-bis(2-ethylhexyl)-[(1,2,4-triazol-1-yl)methyl] amine, 1-[N,N-bis(2-ethylhexyl)aminomethyl]benzotriazole, 1-[N,N-bis(2-ethylhexyl)aminomethyl]tolyltriazole, 1-[N,N-bis(2-ethylhexyl)aminomethyl]carboxybenzotriazole, 1-[N,N-bis(2-hydroxyethyl)-aminomethyl]benzotriazole, 1-[N,N-bis(2-hydroxyethyl)-aminomethyl]tolyltriazole, 1-[N,N-bis(2-hydroxyethyl)-aminomethyl]carboxybenzotriazole, 1-[N,N-bis(2-hydroxypropyl)aminomethyl]carboxybenzotriazole, 1-[N,N-bis(1-butyl)aminomethyl]carboxybenzotriazole, 1-[N,N-bis(1-octyl)aminomethyl]carboxybenzotriazole, 1-(2',3'-di-hydroxypropyl)benzotriazole, 1-(2',3'-di-carboxyethyl)benzotriazole, 2-(2'-hydroxy-3',5'-di-tert-butylphenyl)benzotriazole, 2-(2'-hydroxy-3',5'-amylphenyl)benzotriazole, 2-(2'-hydroxy-4'-octoxyphenyl)benzotriazole, 2-(2'-hydroxy-5'-tert-butylphenyl)benzotriazole, 1-hydroxybenzotriazole-6-carboxylic acid, 1-oleoylbenzotriazole, 1,2,4-triazol-3-ol, 5-amino-3-mercapto-1,2,4-triazole, 5-amino-1,2,4-triazole-3-carboxylic acid, 1,2,4-triazole-3-carboxyamide, 4-aminourazole, and 1,2,4-triazol-5-one.

The content of component (F) is not particularly limited, but is in a range of from 0.000001 to 3 parts by mass, and preferably in a range of from 0.00001 to 1 parts by mass, per 100 parts by mass of components (A) to (D).

The present composition may also contain an adhesion promoter in order to further improve adhesion to a substrate with which the composition makes contact during curing. Such an adhesion promoter is preferably an organosilicon compound having one or more silicon-bonded alkoxy groups per molecule. Examples of the alkoxy groups include methoxy groups, ethoxy groups, propoxy groups, butoxy groups, and methoxyethoxy groups, and methoxy groups or ethoxy groups are particularly preferable. Examples of groups other than alkoxy groups bonding to the silicon atoms of this organosilicon compound include substituted or unsubstituted monovalent hydrocarbon groups such as alkyl groups, alkenyl groups, aryl groups, aralkyl groups, and halogenated alkyl groups; epoxy group-containing monovalent organic groups such as 3-glycidoxypropyl groups, 4-glycidoxybutyl groups, or similar glycidoxyalkyl groups; 2-(3,4-epoxycyclohexyl)ethyl groups, 3-(3,4-epoxycyclohexyl)propyl groups, or similar epoxycyclohexylalkyl groups; and 4-oxiranylbutyl groups, 8-oxiranyloctyl groups, or similar oxiranylalkyl groups; acrylic group-containing monovalent organic groups such as 3-methacryloxypropyl groups; isocyanate groups; isocyanurate groups; and hydrogen atoms. The organosilicon compound preferably has a group that can react with the aliphatic unsaturated hydrocarbon groups or silicon-bonded hydrogen atoms in the present composition. Specifically, the organosilicon compound preferably has silicon-bonded aliphatic unsaturated hydrocarbon groups or silicon-bonded hydrogen atoms.

The content of the adhesion promoter is not particularly limited, but is preferably in a range of from 0.01 to 10 parts by mass, and more preferably in a range of from 0.1 to 3 parts by mass, per 100 parts total mass of components (A) to (D).

This composition may also contain a fluorescent substance as an optional component. This fluorescent substance is exemplified by substances widely used in light emitting diodes (LEDs), such as yellow, red, green, and blue light-emitting fluorescent substances such as oxide fluorescent substances, oxynitride fluorescent substances, nitride fluorescent substances, sulfide fluorescent substances, oxysulfide fluorescent substances, and the like. Examples of oxide fluorescent substances include yttrium, aluminum, and garnet-type YAG green to yellow light-emitting fluorescent substances containing cerium ions; terbium, aluminum, and garnet-type TAG yellow light-emitting fluorescent substances containing cerium ions; and silicate green to yellow light-emitting fluorescent substances containing cerium or europium ions. Examples of oxynitride fluorescent substances include silicon, aluminum, oxygen, and nitrogen-type SiAlON red to green light-emitting fluorescent substances containing europium ions. Examples of nitride fluorescent substances include calcium, strontium, aluminum, silicon, and nitrogen-type CASN red light-emitting fluorescent substances containing europium ions. Examples of sulfide fluorescent substances include ZnS green light-emitting fluorescent substances containing copper ions or aluminum ions. Examples of oxysulfide fluorescent substances include Y₂O₂S red light-emitting fluorescent substances containing europium ions. These fluorescent substances may be used as one type or as a mixture of two or more types.

The content of the fluorescent substance is not particularly limited, but is preferably in the range of from 0.1 to 70 mass% and more preferably in the range of from 1 to 20 mass% of the present composition.

The present composition may also contain one or more types of inorganic fillers selected from silica, glass, alumina, and the like; silicone rubber powders; resin powders such as silicone resins and polymethacrylate resins; and one or more types of components selected from heat resistant agents, dyes, pigments, flame retardants, surfactants, solvents, and the like as other optional components, as long as the object of the present invention is not impaired.

Although the curing of the present composition progresses when left to stand at room temperature or when heated, it is preferable to heat a composition in order to cure the composition quickly. The heating temperature is preferably in a range of from 50 to 200°C.

The present composition preferably forms a cured product with a type A durometer hardness as prescribed in JIS K 6253 from 30 to 99 and particularly preferably from 35 to 95 when cured. This is because the composition has sufficient strength and is sufficiently protective when the hardness of the cured product of the curable silicone composition is not less than the lower limit of the range described above, and the cured product is flexible and sufficiently durable when the hardness is not greater than the upper limit of the range described above.

The present composition preferably forms a cured product of which the change in b value in the CIE Lab standard colorimetric system according to JIS Z 8730 is not greater than 10, and particularly preferably not greater than 5, before and after heating in nitrogen air flow at 200°C for 250 hours. The b value of the cured product of the present composition in the CIE Lab standard colorimetric system according to JIS Z 8730 can be measured using a colorimeter, for example.

### [Optical Semiconductor Device]

The optical semiconductor device of the present invention will now be described in detail.

The optical semiconductor device of the present invention is characterized in that an optical semiconductor element is sealed, covered, or adhered by the composition described above. Specific examples of the optical semiconductor element include light-emitting diodes (LEDs), semiconductor lasers, photodiodes, phototransistors, solid-state image sensing devices, and light emitters and receivers for photocoupler, and the optical semiconductor element is preferably a light-emitting diode (LED).

Since light emission occurs from the top, bottom, left, and right sides of the semiconductor in a light-emitting diode (LED), it is not preferable for the parts constituting the light-emitting diode (LED) to absorb light, and a material with high optical transmittance or high reflectivity is preferable. Therefore, it is also preferable for the substrate on which the optical semiconductor element is mounted to be a material with high optical transmittance or high reflectivity. The board upon which this optical semiconductor element is mounted is exemplified by electrically conductive metals such as silver, gold, copper, or the like; non-electrically conductive metals such as aluminum, nickel, or the like; thermoplastic resins such as PPA, LCP, or the like intermixed with white pigments; thermoplastic resins such as epoxy resins, BT resins, polyimide resins, silicone resins, or the like including white pigment; ceramics such as alumina, aluminum nitride, or the like; or the like. The curable silicone composition has favorable thermal shock resistance with respect to the optical semiconductor element and the substrate, and the resulting optical semiconductor device can demonstrate good reliability.

FIG. 1 shows a cross-sectional drawing of a surface mounted type LED, which is one example of the optical semiconductor device of the present invention. In the LED illustrated in FIG. 1, an optical semiconductor element 1 is die-bonded to a lead frame 2, and the optical semiconductor element 1 and a lead frame 3 are wire-bonded by a bonding wire 4. A light reflection material 5 is formed on the periphery of this optical semiconductor element 1, and the optical semiconductor element 1 inside the light reflection material 5 is sealed by a cured product 6 of the curable silicone composition described above.

An example of a method for producing the surface-mounted LED illustrated in FIG. 1 is a method of die-bonding the optical semiconductor element 1 to the lead frame 2, wire-bonding the optical semiconductor element 1 and the lead frame 3 with a bonding wire 4 made of gold, molding the curable silicone composition by transfer molding or compression molding, and then forming the light reflection material 5 on the periphery of the optical semiconductor element 1. Another example is a method of first forming the light reflection material 5 and then resin-sealing the optical semiconductor element 1 on the inside of the light reflection material 5 with the curable silicone composition described above.

### EXAMPLES

The curable silicone composition and optical semiconductor device of the present invention will be described in detail hereinafter using Practical Examples and Comparative Examples. Furthermore, the hardness of the cured product of the curable silicone composition, the storage stability of the curable silicone composition, and the color change of the cured product were measured as follows.

### [Hardness]

The curable silicone composition was press-molded at 150°C for 1 hour at 5 MPa pressure to produce a sheet-like cured product. The hardness of the sheet-like cured product was measured by type A durometer as specified in JIS K 6253.

### [Storage Stability]

In the curable silicone composition, a composition was prepared without adding a hydrosilylation reaction catalyst, and after storing for 100 hours in a 50°C oven, a curable silicone composition was prepared by adding a hydrosilylation reaction catalyst. After this thermal aging, the type A durometer hardness of the cured product obtained by heating the curable silicone composition at 150°C for 1 hour was measured. If the hardness after the thermal aging was lower than the hardness of the cured product obtained by curing the curable silicone composition before thermal aging, it was considered a "curing defect." Furthermore, the appearance of the curable silicone composition after storage for 100 hours was observed macroscopically.

### [Discoloration]

The curable silicone composition was press-molded at 150°C for 1 hour at 5 MPa pressure to produce a sheet-like cured product. The sheet-like cured product was heated in nitrogen air flow at 200°C for 250 hours. After heating, the b value of the cured product in the CIE Lab standard colorimetric system according to JIS Z 8730 was measured using a colorimeter, and the b value after aging subtracted from the b value before aging was taken as the change in b value.

Furthermore, the optical semiconductor device illustrated in FIG. 1 was produced by heating at 150°C for 1 hour using the curable silicone composition. Sulfur resistance of this optical semiconductor device was measured as follows by measuring radiant flux.

### [Sulfur Resistance]

The initial radiant flux of the optical semiconductor device was measured by a total radiant flux measurement apparatus using integrating spheres. Then, the optical semiconductor device was put into an autoclave with sodium sulfide hexahydrate, heated to 50°C, and left to stand for 100 hours. After that, radiant flux of the optical semiconductor device was measured by a total radiant flux measurement apparatus using integrating spheres.

### [Practical Examples 1 to 9 and Comparative Examples 1 to 8]

Practical Examples 6, 8 and 9 are not according to the invention.

The following components were uniformly mixed according to the compositions (parts by mass) shown in Tables 1 and 2 to prepare the curable silicone compositions of Practical Examples 1 to 9 and Comparative Examples 1 to 8. In the formulae, Vi represents a vinyl group, Me represents a methyl group, and Ph represents a phenyl group. In Tables 1 and 2, SiH/Vi indicates the total number of moles of silicon-bonded hydrogen atoms in component (B) relative to 1 mole of total vinyl groups in component (A) in the curable silicone composition.

The following components were used as component (A). The viscosity was the value at 25°C and was measured using a type B viscometer in accordance with JIS K7117-1.
Component (a-1): methylphenylpolysiloxane (vinyl group content = 1.27 mass%, 3.03 mol%) having a viscosity of 1,000 mPa·s, having the following average formula:

   Me₂ViSiO(MePhSiO)₃₀SiMe₂Vi
Component (a-2): methylphenylpolysiloxane (vinyl group content = 0.33 mass%, 0.81 mol%) having a viscosity of 15,000 mPa·s, having the following average formula:

   Me₂ViSiO(MePhSiO)₁₂₀SiMe₂Vi
Component (a-3): dimethylpolysiloxane capped at both molecular terminals with dimethylvinylsiloxy groups (vinyl group content = 0.48 mass%, 0.65 mol%) having a viscosity of 300 mPa·s, having the following average formula:

   Me₂ViSiO(Me₂SiO)₁₅₀SiMe₂Vi
Component (a-4): dimethylpolysiloxane capped at both molecular terminals with dimethylvinylsiloxy groups (vinyl group content = 0.15 mass%, 0.20 mol%) having a viscosity of 10,000 mPa·s, having the following average formula:

   Me₂ViSiO(Me₂SiO)₅₀₀SiMe₂Vi
Component (a-5): organopolysiloxane having not less than two vinyl groups per molecule (vinyl group content = 5.6 mass%, 16.7 mol%), which is a white solid at 25°C and which is soluble in toluene, having the average unit formula:

   (PhSiO_{3/2})_{0.75}(Me₂ViSiO_{1/2})_{0.25}
Component (a-6): organopolysiloxane having not less than two vinyl groups per molecule (vinyl group content = 4.6 mass%, 15.7 mol%), which is a white solid at 25°C and which is soluble in toluene, having the average unit formula:

   (MePhViSiO_{1/2})_{0.23}(PhSiO_{3/2})_{0.77}
Component (a-7): organopolysiloxane having not less than two vinyl groups per molecule (vinyl group content = 5.6 mass%, 9.43 mol%), which is a white solid at 25°C and which is soluble in toluene, having the average unit formula:

   (Me₂ViSiO_{1/2})_{0.15}(Me₃SiO_{1/2})_{0.38}(SiO_{4/2})_{0.47}
Component (a-8): organopolysiloxane resin having not less than two vinyl groups per molecule (vinyl group content = 4.7 mass%, 7.60 mol%), which is a white solid at 25°C and which is soluble in toluene, having the average unit formula:

   (Me₂ViSiO_{1/2})_{0.13}(Me₃SiO_{1/2})_{0.45}(SiO_{4/2})_{0.42}

The following components were used as component (B). The viscosity was the value at 25°C and was measured using a type B viscometer in accordance with JIS K7117-1.
Component (b-1): diphenylpolysiloxane capped at both molecular terminals with dimethylhydrogensiloxy groups (content of silicon-bonded hydrogen atoms = 0.6 mass%) having a viscosity of 5 mPa·s, having the following average formula:

   HMe₂SiO(Ph₂SiO)SiMe₂H
Component (b-2): branched-chain organopolysiloxane having not less than two silicon-bonded hydrogen atoms per molecule (content of silicon-bonded hydrogen atoms = 0.65 mass%) having viscosity of 25 mPa·s, having the average unit formula:

   (PhSiO_{3/2})_{0.4}(HMe₂SiO_{1/2})_{0.6}
Component (b-3): polymethylhydrogensiloxane capped at both molecular terminals with trimethylsiloxy groups (content of silicon-bonded hydrogen atoms = 1.6 mass%) having a viscosity of 20 mPa·s, having the following average formula:

   Me₃SiO(MeHSiO)₅₅SiMe₃
Component (b-4): copolymer of methylhydrogensiloxane and dimethylsiloxane capped at both molecular terminals with trimethylsiloxy groups (content of silicon-bonded hydrogen atoms =1.42 mass%) having a viscosity of 5 mPa·s, having the following average formula:

   Me₃SiO(MeHSiO)₁₅SiMe₃

The following components were used as component (C).
Component (c-1): zinc oxide fine powder surface-coated with Al(OH)₃ and SiO₂ hydrate, having a mass-average particle diameter of 1.0 µm
Component (c-2): zinc oxide fine powder having a mass-average particle diameter of 30 nm surface-treated with copolymer of methylhydrogensiloxane and dimethylsiloxane capped at both molecular terminals with trimethylsiloxy groups and having a viscosity of 20 mPa·s
Component (c-3): zinc oxide fine powder surface-coated with SiO₂ having a mass-average particle diameter of 0.5 µm, further coated with zinc oxide fine powder surface-treated with copolymer of methylhydrogensiloxane and dimethylsiloxane capped at both molecular terminals with trimethylsiloxy groups and having a viscosity of 20 mPa·s
Component (c-4): fine powder of a hydrate of zinc carbonate having a mass-average particle diameter of 0.5 µm, in which the rate of mass decrease is 0.4 mass% under heating conditions of 105°C for 3 hours
Component (c-5): zinc oxide fine powder having a mass-average particle diameter of 10 nm surface-treated with acid
Component (c-6): zinc oxide fine powder having a mass-average particle diameter of 0.5 µm
Component (c-7): zinc oxide fine powder having a mass-average particle diameter of 10 µm surface-coated with Al(OH)₃ and SiO₂ hydrate
Component (c-8): bis(2-ethylhexanoyloxy) zinc

As component (D), a 1,3-divinyltetramethyldisiloxane solution of a platinum complex of 1,3-divinyltetramethyldisiloxane (platinum metal content in component = approximately 4,000 ppm in terms of mass units) was used.

As component (E), 1-ethynylcyclohexan-1-ol was used.

As component (F), benzotriazole was used.

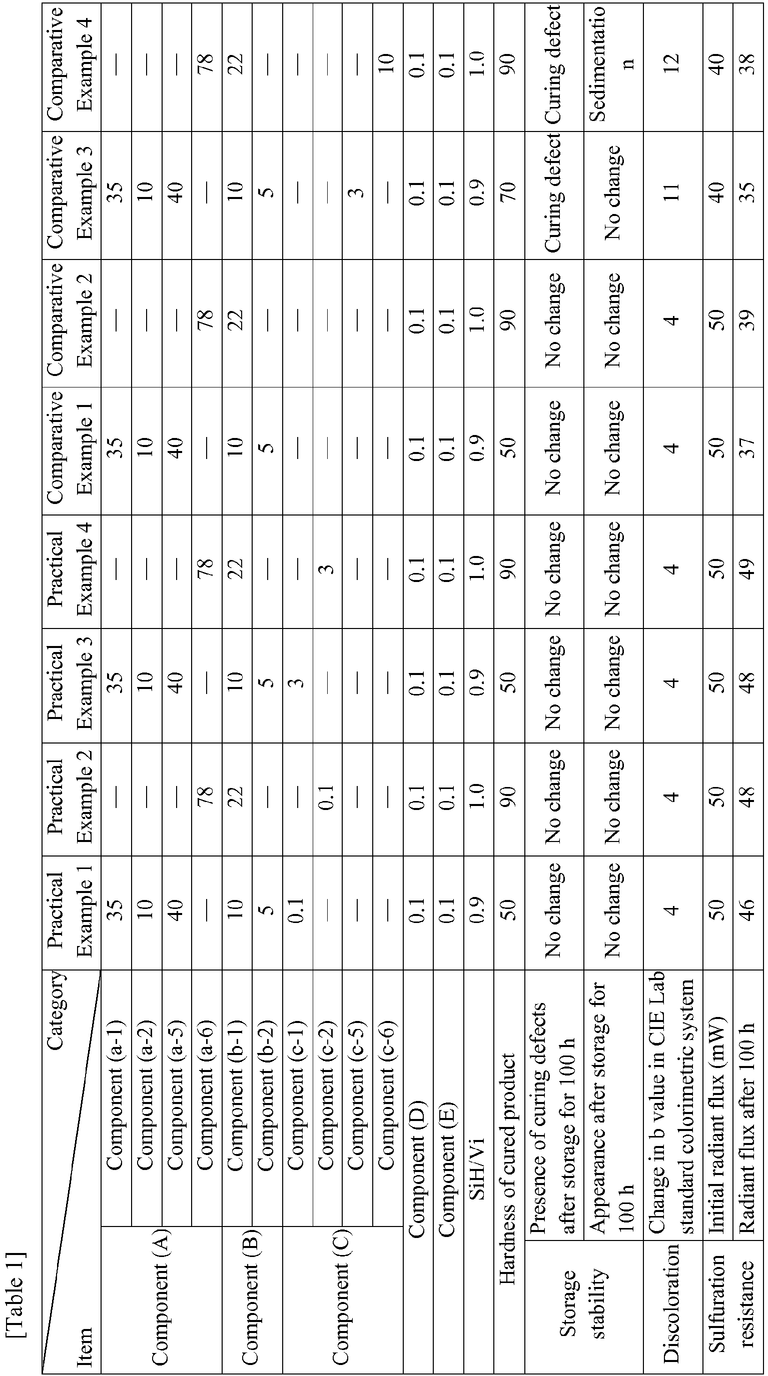

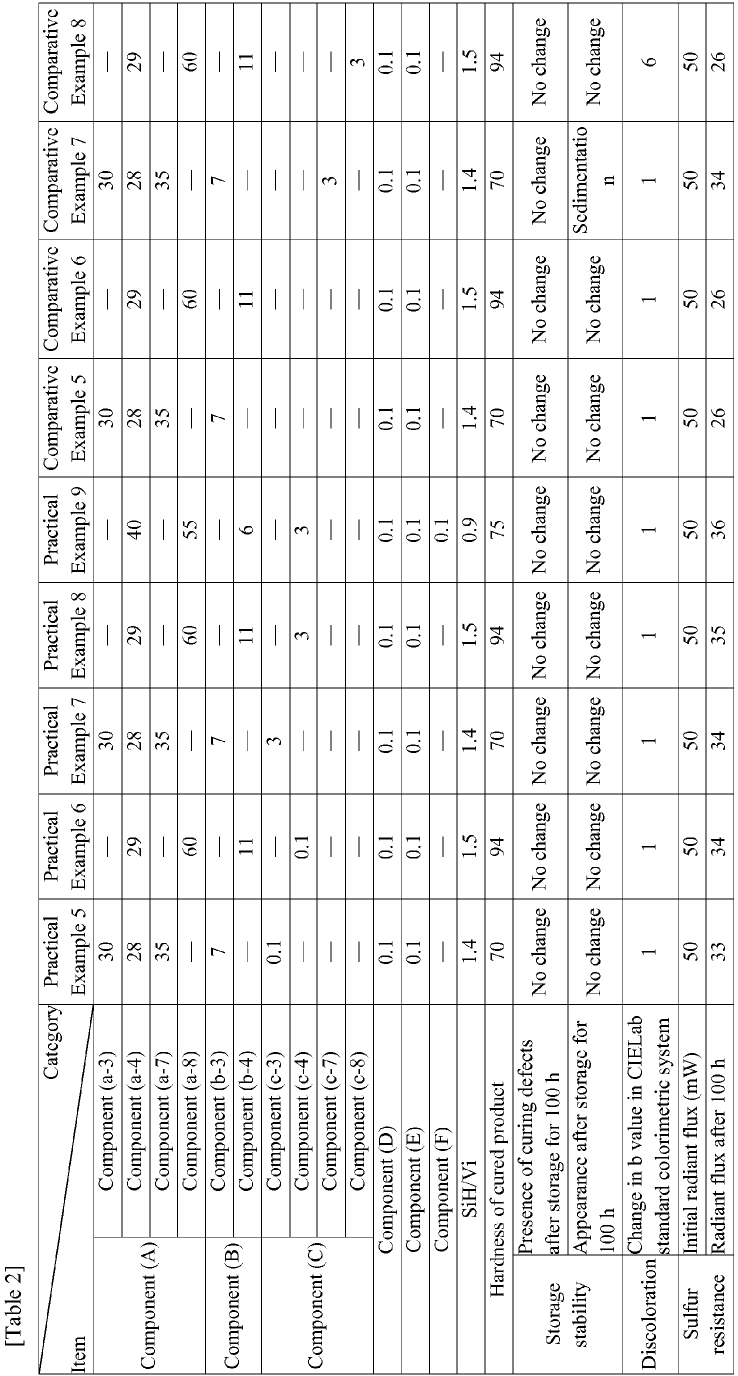

From Tables 1 and 2, it was ascertained that the curable silicone compositions of Practical Examples 1 to 9 had good storage stability, the cured products thereof had resistance to discoloration, and the optical semiconductor devices produced using those compositions had sulfur resistance.

### INDUSTRIAL APPLICABILITY

The curable silicone composition of the present invention has excellent storage stability, and when cured, forms a cured product that undergoes minimal yellowing due to thermal aging and sufficiently suppresses discoloration of silver electrodes and silver plating of substrates due to sulfur-containing gas in the air. As a result, it is advantageous as a sealing agent, coating agent, or adhesive agent of optical semiconductor elements or a protective agent of silver electrodes of liquid crystal terminals and silver plating of substrates in optical semiconductor devices.

### REFERENCE NUMERALS

- 1: Optical semiconductor element
- 2: Lead frame
- 3: Lead frame
- 4: Bonding wire
- 5: Reflective member
- 6: Cured product of the curable silicone composition

## Claims

1. A curable silicone composition comprising at least:
(A) an organopolysiloxane having at least two silicon-bonded alkenyl groups per molecule;
(B) an organopolysiloxane having at least two silicon-bonded hydrogen atoms per molecule, in an amount such that a content of the silicon-bonded hydrogen atoms in this component is from 0.1 to 10 moles per 1 mole of the alkenyl groups in component (A);
(C) at least one type of fine powder having mass-average particle diameter of from 0.1 nm to 5 µm, selected from the group consisting of zinc oxide fine powders surface-coated with an oxide and/or hydroxide of at least one element selected from the group consisting of Al, Ag, Cu, Fe, Sb, Si, Sn, Ti, Zr, and rare earth elements, and zinc oxide fine powders surface-treated with an organosilicon compound not having an alkenyl group_ selected from the group consisting of organosilazans and organohydrogenpolysiloxanes, in an amount of from 1 ppm to 10% of the composition in terms of mass units; and
(D) an effective amount of a hydrosilylation reaction catalyst, wherein the mass-average particle diameter is determined as disclosed in the specification.

2. The curable silicone composition according to claim 1, wherein component (A) is an organopolysiloxane expressed by the average unit formula:
(R¹SiO_{3/2})ₐ(R²R³SiO_{2/2})_{b}(R⁴R⁵R⁶SiO_{1/2})_{c}(SiO_{4/2})_{d}
wherein, R¹ to R⁶ are identical or different types of monovalent hydrocarbon group; from 0.01 to 50 mol% of all of the monovalent hydrocarbon groups are alkenyl groups; a, b, c, and d are numbers satisfying: 0 ≤ a ≤ 1.0, 0 ≤ b ≤ 1.0, 0 ≤ c < 0.9, 0 ≤ d < 0.5, and a + b + c + d = 1.0.

3. The curable silicone composition according to claim 1, further comprising (E) a hydrosilylation reaction inhibitor in an amount of from 0.0001 to 5 parts by mass per 100 parts by mass of the total of components (A) to (D).

4. The curable silicone composition according to any one of claims 1 to 3, further comprising (F) a triazole compound, in an amount of from 0.000001 to 3 parts by mass per 100 parts by mass of the total of components (A) to (D).

5. The curable silicone composition according to any one of claims 1 to 4, which forms a cured product of which a change in b value in a CIE Lab standard colorimetric system according to JIS Z 8730 is not greater than 10 before and after heating in a nitrogen atmosphere at 200°C for 250 hours.

6. Use of the curable silicone composition according to any one of claims 1 to 5, for sealing, covering, or adhering an optical semiconductor element in an optical semiconductor device.

7. An optical semiconductor device obtained by sealing, covering, or adhering an optical semiconductor element in an optical semiconductor device using the curable silicone composition described in any one of claims 1 to 5.

8. The optical semiconductor device according to claim 7, wherein the optical semiconductor element is a light-emitting diode.

## Patentansprüche

1. Härtbare Silicon-Zusammensetzung, mindestens umfassend:
(A) ein Organopolysiloxan, das mindestens zwei siliciumgebundene Alkenyl-Gruppen pro Molekül aufweist;
(B) an Organopolysiloxan, das mindestens zwei siliciumgebundene Wasserstoffatome pro Molekül in einer solchen Menge aufweist, dass ein Gehalt der siliciumgebundenen Wasserstoffatome in dieser Komponente von 0,1 bis 10 Molen pro 1 Mol der Alkenyl-Gruppen in Komponente (A) beträgt;
(C) mindestens eine Sorte von Feinpulver, das einen massegemittelten Partikeldurchmesser von 0,1 nm bis 5 µm aufweist, ausgewählt ist aus der Gruppe bestehend aus Zinkoxid-Feinpulvern, die mit einem Oxid und/oder Hydroxid von mindestens einem Element oberflächenbeschichtet sind, das ausgewählt ist aus der Gruppe bestehend aus Al, Ag, Cu, Fe, Sb, Si, Sn, Ti, Zr und Seltenerdelementen, und Zinkoxid-Feinpulvern, die mit einer Organosilicium-Verbindung oberflächenbehandelt sind, die keine Alkenyl-Gruppe aufweist, und die ausgewählt ist aus der Gruppe bestehend aus Organosilazanen und Organohydrogenpolysiloxanen in einer Menge von 1 ppm bis 10% der Zusammensetzung auf Masseeinheiten bezogenen; und
(D) eine wirksame Menge eines Katalysators zur Hydrosilylierungsreaktion, wobei der massegemittelte Partikeldurchmesser bestimmt wird, wie er in der Patentschrift offenbart wird.

2. Härtbare Silicon-Zusammensetzung nach Anspruch 1, wobei Komponente (A) ein Organopolysiloxanen ist, das dargestellt wird mit Hilfe der durchschnittlichen Einheitsformel:
(R¹SiO_{3/2})ₐ(R²R³SiO_{2/2})_{b}(R⁴R⁵R⁶SiO_{1/2})_{c}(SiO_{4/2})_{d}
wobei R¹ bis R⁶ identische oder verschiedene Sorten einer einwertigen Kohlenwasserstoff-Gruppe sind; von 0,01 bis 50 Mol-% von allen den einwertigen Kohlenwasserstoff-Gruppen Alkenyl-Gruppen sind; a, b, c und d Zahlen sind, die 0 ≤ a ≤ 1,0, 0 ≤ b ≤ 1,0, 0 ≤ c < 0,9, 0 ≤ d < 0,5 und a + b + c + d = 1,0 genügen.

3. Härtbare Silicon-Zusammensetzung nach Anspruch 1, ferner umfassend (E) einen Inhibitor einer Hydrosilylierungsreaktion in einer Menge von 0,0001 bis 5 Masseteilen pro 100 Masseteile der Gesamtheit der Komponenten (A) bis (D).

4. Härtbare Silicon-Zusammensetzung nach einem der Ansprüche 1 bis 3, ferner umfassend (F) eine Triazol-Verbindung in einer Menge von 0,000001 bis 3 Gewichtsteilen pro 100 Gewichtsteile der Gesamtheit der Komponenten (A) bis (D).

5. Härtbare Silicon-Zusammensetzung nach einem der Ansprüche 1 bis 4, die ein gehärtetes Produkt bildet, bei dem eine Änderung im Wert b in einem kolorimetrischen CIE-Lab-Standardsystem nach JIS Z 8730 vor und nach dem Erhitzen für 250 Stunden in einer Stickstoffatmosphäre bei 200°C nicht größer ist als 10.

6. Verwendung der härtbaren Silicon-Zusammensetzung nach einem der Ansprüche 1 bis 5 zum Abdichten, Abdecken oder Adhärieren eines optischen Halbleiterelements in einer optischen Halbleitervorrichtung.

7. Optische Halbleitervorrichtung, die durch Versiegeln, Abdecken oder Adhärieren eines optischen Halbleiterelements in einer optischen Halbleitervorrichtung erhalten wird, indem die nach einem der Ansprüche 1 bis 5 beschriebene härtbaren Silicon-Zusammensetzung verwendet wird.

8. Optische Halbleitervorrichtung nach Anspruch 7, wobei das optische Halbleiterelement eine lichtemittierende Diode ist.

## Revendications

1. Composition de silicone durcissable comprenant au moins :
(A) un organopolysiloxane qui comporte au moins deux groupes alkényle liés au silicium par molécule ;
(B) un organopolysiloxane qui comporte au moins deux atomes d'hydrogène liés au silicium par molécule, en une quantité telle qu'une teneur des atomes d'hydrogène liés au silicium dans ce composant va de 0,1 à 10 moles pour 1 mole des groupes alkényle dans le composant (A) ;
(C) au moins un type de poudre fine qui présente un diamètre de particule moyen en masse qui va de 0,1 nm à 5 µm, sélectionné parmi le groupe qui est constitué par des poudres fines d'oxyde de zinc qui sont revêtues en surface par un oxyde et/ou un hydroxyde d'au moins un élément qui est sélectionné parmi le groupe constitué par Al, Ag, Cu, Fe, Sb, Si, Sn, Ti, Zr, et les éléments des terres rares, et des poudres fines d'oxyde de zinc qui sont traitées en surface avec un composé d'organosilicium qui ne comporte pas de groupe alkényle, sélectionné parmi le groupe qui est constitué par les organosilazans et les organohydrogènpolysiloxanes, en une quantité qui va de 1 ppm à 10 % de la composition en termes d'unités de masse ; et
(D) une quantité efficace d'un catalyseur de réaction d'hydosilylation, dans laquelle le diamètre de particule moyen en masse est déterminé tel que divulgué dans la description.

2. Composition de silicone durcissable selon la revendication 1, dans laquelle le composant (A) est un organopolysiloxane qui est exprimé par la formule unitaire moyenne :
(R¹SᵢO_{3/2})ₐ(R²R³SiO_{2/2})_{b}(R⁴R⁵R⁶SiO_{1/2})_{c}(SiO_{4/2})_{d}
dans laquelle R¹ à R⁶ sont des types identiques ou différents de groupe hydrocarbone monovalent ; de 0,01 à 50 % mol de tous les groupes hydrocarbone monovalents sont des groupes alkényle ; a, b, c et d sont des nombres qui satisfont : 0 ≤ a ≤ 1,0, 0 ≤ b ≤ 1,0, 0 ≤ c < 0,9, 0 ≤ d < 0,5, et a + b + c + d = 1,0.

3. Composition de silicone durcissable selon la revendication 1, comprenant en outre (E) un inhibiteur de réaction d'hydrosilylation en une quantité qui va de 0,0001 à 5 parties en masse pour 100 parties en masse du total des composants (A) à (D).

4. Composition de silicone durcissable selon l'une quelconque des revendications 1 à 3, comprenant en outre (F) un composé de triazole en une quantité qui va de 0,000001 à 3 parties en masse pour 100 parties en masse du total des composants (A) à (D).

5. Composition de silicone durcissable selon l'une quelconque des revendications 1 à 4, laquelle forme un produit durci dont une variation de la valeur b dans un système colorimétrique standard CIE Lab conformément à JIS Z 8730 n'est pas supérieure à 10 avant et après chauffage dans une atmosphère d'azote à 200 °C pendant 250 heures.

6. Utilisation de la composition de silicone durcissable selon l'une quelconque des revendications 1 à 5, pour le scellement, le recouvrement ou la fixation par adhérence d'un élément optique à semiconducteur dans un dispositif optique à semiconducteur.

7. Dispositif optique à semiconducteur obtenu par scellement, recouvrement ou fixation par adhérence d'un élément optique à semiconducteur dans un dispositif optique à semiconducteur en utilisant la composition de silicone durcissable décrite selon l'une quelconque des revendications 1 à 5.

8. Dispositif optique à semiconducteur selon la revendication 7, dans lequel l'élément optique à semiconducteur est une diode électroluminescente.
